(19)

Europäisches
Patentamt

European
Patent Office

Office européen
des brevets

(11) **EP 2 982 991 A1**

(12) **EUROPEAN PATENT APPLICATION**
published in accordance with Art. 153(4) EPC

(43) Date of publication:
**10.02.2016 Bulletin 2016/06**

(21) Application number: **14779780.7**

(22) Date of filing: **01.04.2014**

(51) Int Cl.:
**G01P 21/00** (2006.01)     **G01P 15/125** (2006.01)
**G01P 15/18** (2006.01)

(86) International application number:
**PCT/JP2014/059634**

(87) International publication number:
**WO 2014/163076 (09.10.2014 Gazette 2014/41)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **02.04.2013 JP 2013077145**

(71) Applicant: **Fuji Electric Co., Ltd.
Kawasaki-shi, Kanagawa 210-9530 (JP)**

(72) Inventors:
• **KAKINUMA Minoru
Kawasaki-shi
Kanagawa 210-9530 (JP)**
• **KISHIRO Masami
Kawasaki-shi
Kanagawa 210-9530 (JP)**

(74) Representative: **Appelt, Christian W.
Boehmert & Boehmert
Anwaltspartnerschaft mbB
Patentanwälte Rechtsanwälte
Pettenkoferstrasse 20-22
80336 München (DE)**

(54) **CAPACITANCE TYPE SENSOR, AND METHOD FOR CORRECTING NON-LINEAR OUTPUT**

(57)     An electrostatic capacitance sensor (10) includes a movable electrode (110), a support (120), a beam member (130), fixed electrodes (141) an (180), a detection unit (200), and a correction unit (300). The beam member (130) functions as a spring, by which the movable electrode (110) is fixed to the support (120) in a movable state. The detection unit (200) detects a change in capacitance charged between the movable electrode (110) and the fixed electrodes (141) and (180). The correction unit (300) corrects a detection result of the detection unit (200) and generates an acceleration signal that indicates acceleration.

FIG. 1

EP 2 982 991 A1

**Description**

TECHNICAL FIELD

The present invention relates to an electrostatic capacitance sensor that detects acceleration, and a method for correcting non-linear output.

BACKGROUND ART

The capacitance type apparatus disclosed in Patent Document 1, for example, is an acceleration detection apparatus that detects acceleration. According to this capacitance type apparatus, a fixed electrode is disposed near a movable electrode, and acceleration is detected by detecting the change in the capacitance between the fixed electrode and the movable electrode.

Patent Documents 1, 2 and 3 disclose that the relationship between the change in the capacitance and the displacement of the movable electrode is non-linear. Further, Patent Documents 1, 2 and 3 disclose that the displacement of the movable electrode is so small that the relationship between the change in the capacitance and the displacement of the movable electrode is regarded as linear.

According to the acceleration sensors disclosed in Patent Documents 4 and 5, the relationship between the change in the capacitance and the displacement of the movable electrode is regarded as non-linear, and this non-linearity is corrected. The acceleration sensor disclosed in Patent Document 4 is a cylindrical triaxial acceleration sensor. This acceleration sensor detects acceleration for each of the three axes based on the change in the capacitance between an electrode on a fixed disk and an electrode on a movable disk, which face each other with respect to the extending direction of the cylinder. The acceleration sensor disclosed in Patent Document 5 detects acceleration in one direction.

Patent Document 1: Japanese Patent Application Laid-Open No. H2-110383
Patent Document 2: Japanese Patent Application Laid-Open No. H5-72225
Patent Document 3: Japanese Patent Application Laid-Open No. H5-340958
Patent Document 4: Japanese Patent Application Laid-Open No. H8-313552
Patent Document 5: Japanese Patent Application Laid-Open No. H7-120498

DISCLOSURE OF THE INVENTION

The present inventors examined the construction of an electrostatic capacitance sensor that has a movable electrode and a plurality of fixed electrodes which faces the movable electrode from different directions respectively. Further, the inventors examined a method for accurately detecting acceleration for each of the plurality of directions for this electrostatic capacitance sensor.

With the foregoing in view, it is an object of the present invention to provide an electrostatic capacitance sensor that has a movable electrode and a plurality of fixed electrodes which faces the movable electrode from different directions respectively, and that can accurately detect the accleration for each of the plurality of directions and a correction method used therein.

An electrostatic capacitance sensor according to the present invention includes a movable electrode, a support, a beam member, a first fixed electrode, a second fixed electrode, a detection unit and a correction unit. The beam member attaches the movable electrode to the support member in a movable state. The first fixed electrode faces the movable electrode from a first direction. The second fixed electrode faces the movable electrode from a second direction which is different from the first direction. The detection unit detects a change in capacitance charged between the movable electrode and each of the fixed electrodes. The correction unit corrects a detection result of the detection unit, and generates an acceleration signal which indicates acceleration.

A method for correcting non-linear output according to the present invention is a method for correcting output of the detection unit of the above mentioned electrostatic capacitance sensor. First a theoretical formula, to calculate the capacitance from acceleration, is calculated using the distances between the movable electrode and the fixed electrodes and a spring constant of the beam member. Then the output of the detection unit is corrected using an inversion formula of the theoretical formula.

According to the present invention, in an electrostatic capacitance sensor that has a movable electrode and a plurality of fixed electrodes which faces the movable electrode from different directions respectively, acceleration can be accurately detected for each of the plurality of directions.

BRIEF DESCRIPTION OF THE DRAWINGS

These and other objects, features and advantages will become more apparent upon reading the following detailed description on the embodiments, along with the accompanying drawings.

Fig. 1 is a plan view depicting a configuration of an electrostatic capacitance sensor according to Embodiment 1;
Fig. 2 is a cross-sectional view at A-A' in Fig. 1;
Fig. 3 is a diagram depicting a circuit configuration of a detection unit of the electrostatic capacitance sensor;
Fig. 4 is a diagram depicting a movement of a movable electrode when acceleration in the X direction shown in Figs. 1 and 2 is applied to the movable electrode of the electrostatic capacitance sensor;
Fig. 5 is a graph showing the relationship between the output from the detection unit and the acceleration G;
Fig. 6 is a graph showing a correction formula shown in Expression (6) and output after the output $\Delta C$ shown in Fig. 5 is corrected using this correction formula (first acceleration signal);
Fig. 7 is a diagram depicting a circuit configuration of the detection unit of the electrostatic capacitance sensor;
Fig. 8 is a diagram depicting a movement of the movable electrode when acceleration in the Z direction shown in Fig. 2 is applied to the movable electrode of the electrostatic capacitance sensor;
Fig. 9 is a graph showing a relationship between the output from the detection unit and the acceleration G;
Fig. 10 is a graph showing a correction formula shown in Expression (11) and output after the output shown in Fig. 9 is corrected using this correction formula (second acceleration signal);
Fig. 11 is a diagram depicting a functional configuration of an electrostatic capacitance sensor according to Embodiment 2;
Fig. 12 is a diagram depicting a functional configuration of an electrostatic capacitance sensor according to Embodiment 2;
Fig. 13 is a diagram depicting a positional relationship between fixed electrodes and a movable electrode, in the initial state, of the electrostatic capacitance sensor in the X direction shown in Figs. 1 and 2;
Fig. 14 is a diagram depicting a movement of the movable electrode when acceleration in the X direction shown in Figs. 1 and 2 is applied to the movable electrode of the electrostatic capacitance sensor;
Fig. 15 is a graph showing a relationship between output from a detection unit and acceleration G according to Embodiment 3;
Fig. 16 is a graph showing a correction formula shown in Expression (19) and output after the output $\Delta C$ shown in Fig. 15 is corrected using this correction formula (first acceleration signal);
Fig. 17 is a diagram depicting a positional relationship between the movable electrode and the fixed electrode, in the initial state, of the electrostatic capacitance sensor in the Z direction shown in Fig. 2;
Fig. 18 is a diagram depicting a movement of the movable electrode when acceleration in the Z direction shown in Fig. 2 is applied to the movable electrode of the electrostatic capacitance sensor;
Fig. 19 is a graph showing the relationship between the output $\Delta C$ and the acceleration G when the initial deviation is $d_{ofst} \neq 0$ in Fig. 13; and
Fig. 20 shows diagrams depicting a range of acceleration that can be applied, using gravitational acceleration, to a housing of an electrostatic capacitance sensor.

BEST MODE FOR CARRYING OUT THE INVENTION

Embodiments of the present invention will now be described with reference to the drawings. Similar composing elements are denoted in all the drawings with a same reference symbol, for which redundant description may be omitted.
In the following description, each composing element of a detection unit 200 and a correction unit 300 is a composing element not in hardware units but in functional block units. The detection unit 200 and the correction unit 300 are implemented by a combination of hardware and software, including a computer CPU, memory, programs loaded in memory, storage media, such as a hard disk, for storing programs, and an interface for network connection. There are various modifications of the implementation method.

(Embodiment 1)

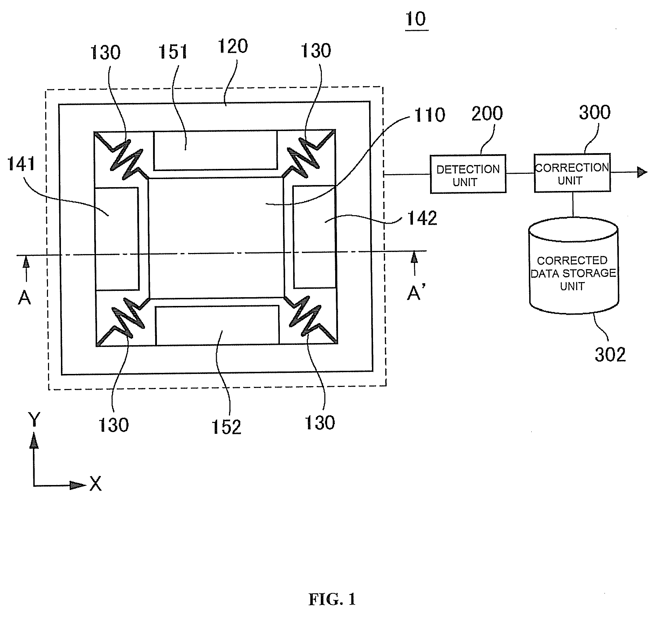

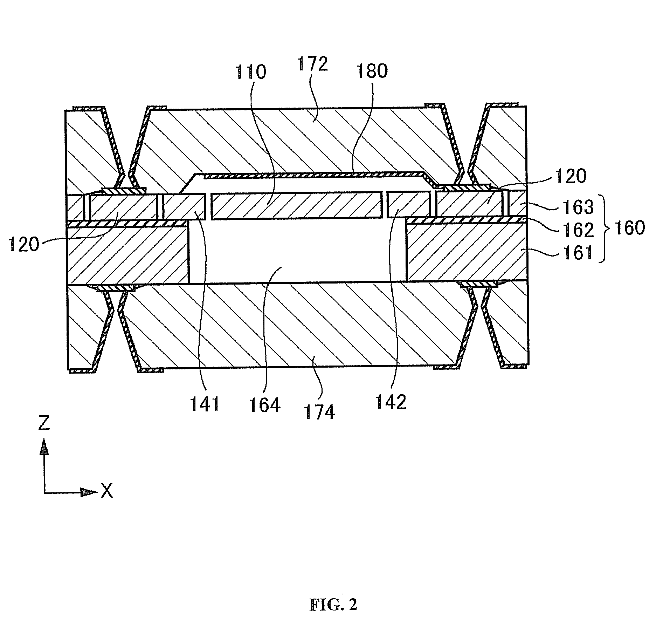

Fig. 1 is a plan view depicting a configuration of an electrostatic capacitance sensor 10 according to Embodiment 1. Fig. 2 is a cross-sectional view at A-A' in Fig. 1. The electrostatic capacitance sensor 10 according to Embodiment 1 includes a movable electrode 110, a support 120, a beam member 130, fixed electrodes 141 and 142, a detection unit 200 and a correction unit 300. The beam member 130 functions as a spring, whereby the movable electrode 110 is attached to the support 120 in a movable state. The detection unit 200 detects a change in the capacitance charged between the movable electrode 110 and the fixed electrodes 141 and 142. The correction unit 300 corrects the detection result of the detection unit 200, and generates an acceleration signal which indicates the acceleration.

According to this embodiment, the acceleration signal has a value generated by correcting the detection result of the detection unit 200. Therefore the relationship between the change in the capacitance and the acceleration signal can be non-linear. As a result, the acceleration can be accurately detected. Now the electrostatic capacitance sensor 10 will be described in detail.

The movable electrode 110 has a plate shape which is rectangular in a plan view. The fixed electrode 141 (first fixed electrode) faces a first side (edge) of the movable electrode 110, and the fixed electrode 142 (second fixed electrode) faces the side (second side) facing the first side of the movable electrode 110. The fixed electrodes 141 and 142 face each other via the movable electrode 110, and are disposed in positions which are line-symmetric with respect to a line that passes through the center of the movable electrode 110 and that is parallel with the first side.

In the example illustrated in Fig. 1, the sides of the movable electrode 110 are all linear. However each of these sides may be comb-shaped (electrode). In this case, the sides of the fixed electrodes 141 and 142 that face the movable electrodes 110 are also comb-shaped (electrode), so as to engage with the movable electrode 110.

The support 120 is disposed so as to surround the four sides of the movable electrode 110. To be more precise, the support 120 has a rectangular opening. The four sides of this opening are parallel with the four sides of the movable electrode 110 respectively. The beam member 130 is disposed at four locations. One end of each beam member 130 is installed to a corner of the movable electrode 110, and the other end thereof is installed to a corner of the opening of the support 120. The arrangement of the beam members 130 however is not limited to the example of Fig. 1.

The electrostatic capacitance sensor 10 also includes fixed electrodes 151 and 152. The fixed electrode 151 faces the third side of the movable electrode 110, and the fixed electrode 152 faces the side (fourth side) facing the third side of the movable electrode 110.

In Fig. 2, the electrostatic capacitance sensor 10 is constituted by an SOI (Silicon On Insulator) substrate 160. The SOI substrate 160 is constituted by a handle silicon layer 161 which is an underlayer, a silicon oxide layer 162 which is formed on the handle silicon layer 161, and an active silicon layer 163 which is formed on the silicon oxide layer 162. Then the handle silicon layer 161 and the silicon oxide layer 162 are removed by etching, except for the portion surrounding th four sides of the movable electrode 110 (support 120). In this way, a space 164 is formed at the center of the handle silicon layer 161 and the silicon oxide layer 162.

The active silicon layer 163 on the top portion is partially removed by anisotropic dry etching, for example. By partially removing the active silicon layer 163, the movable electrode 110 located at the center, the beam members 130 (elastic members) that extend outward on diagonal lines from the four corners of the movable electrode 110, and the fixed electrodes 141, 142, 151 and 152 that face the four sides of the movable electrode 110 via a predetermined interval are formed.

The electrostatic capacitance sensor 10 also includes protective members 172 and 174. The protective members 172 and 174 are formed by glass, for example. The protective member 172 covers a surface of the substrate 160 on which the movable electrode 110 is formed (front face), and the protective member 174 covers the rear face of the substrate 160. The protective members 172 and 174 are separated from the movable electrode 110 except for the edges. The fixed electrode 180 (third fixed electrode) is formed on the surface of the protective member 172 facing the movable electrode 110. This means that the fixed electrode 180 faces the movable electrode 110 from a direction that is different from the fixed electrodes 141, 142, 151 and 152. In other words, the fixed electrodes 141 and 142 face the movable electrode 110 from a first direction (X direction shown in Fig. 1 and Fig. 2), and the fixed electrode 180 faces the movable electrode 110 from the second direction (Z direction shown in Fig. 2). The second direction is a direction facing the front face or the rear face of the movable electrode 110.

Based on the change in the capacitance between the movable electrode 110 and the fixed electrode 141 (first capacitance) and the change in the capacitance between the movable electrode 110 and the fixed electrode 142 (second capacitance), the correction unit 300 detects a component perpendicular to the first side of the movable electrode 110 (component in the X direction in Fig. 1 and Fig. 2: acceleration in the first direction) out of the acceleration applied to the movable electrode 110, and outputs a first acceleration signal that indicates a detected magnitude of the acceleration. In concrete terms, the capacitance between the movable electrode 110 and the fixed electrode 141 changes in a direction that is opposite from that of the capacitance between the movable electrode 110 and the fixed electrode 142. Therefore the structure of the electrostatic capacitance sensor 10 to detect the component perpendicular to the first side of the movable electrode 110, out of the acceleration applied to the movable electrode 110, has a differential structure that is symmetrical in the X direction.

Further, based on the change in the capacitance between the movable electrode 110 and the fixed electrode 151 and the change in the capacitance between the movable electrode 110 and the fixed electrode 152, the correction unit 300 detects a component parallel with the first side of the movable electrode 110 (component in Y direction in Fig. 1) out of the acceleration applied to the movable electrode 110, and outputs an acceleration signal that indicates a detected magnitude of the acceleration. The electrostatic capacitance sensor 10 has a differential structure that is symmetrical in the Y direction when the component parallel with the first side of the movable electrode 110, out of the acceleration applied to the movable electrode 110, is detected.

Furthermore, based on the change in the capacitance between the movable electrode 110 and the fixed electrode 180 (third capacitance), the correction unit 300 detects a component perpendicular to the movable electrode 110 (component in Z direction in Fig. 2) out of the acceleration applied to the movable electrode 110, and outputs a second acceleration signal that indicates a detected magnitude of the acceleration. In this way, the electrostatic capacitance sensor 10 has a structure that is asymmetric in the Z direction when the component perpendicular to the movable electrode 110, out of the acceleration applied to the movable electrode 110, is detected.

The correction method used by the correction unit 300 differs depending on the combination of the movable electrode 110 and the fixed electrode. In concrete terms, the correction method, that is used to detect a component perpendicular to the movable electrode 110 (component in Z direction in Fig. 2) out of the acceleration applied to the movable electrode 110, is different from the correction method that is used to detect a component perpendicular to the first side of the movable electrode 110 (component in X direction in Figs. 1 and 2), out of the acceleration applied to the movable electrode 110.

These correction methods are set as follows, for example. First a theoretical formula, to calculate capacitance from acceleration, is calculated using the distances between the movable electrode and the fixed electrodes and a spring constant of the beam member. Then the correction method is set by using the inversion formula of the theoretical formula.

The correction method used by the correction unit 300 is stored in the correction data storage unit 302. The correction data storage unit 302 stores a correction table, for example. The correction unit 300 generates an acceleration signal based on a correction formula using this correction table. For example, the correction unit 300 calculates a polygonal line as an approximation of the correction formula by connecting two adjacent points out of a plurality of points stored in the correction table. Thus the operation load applied to the correction unit 300 can be decreased.

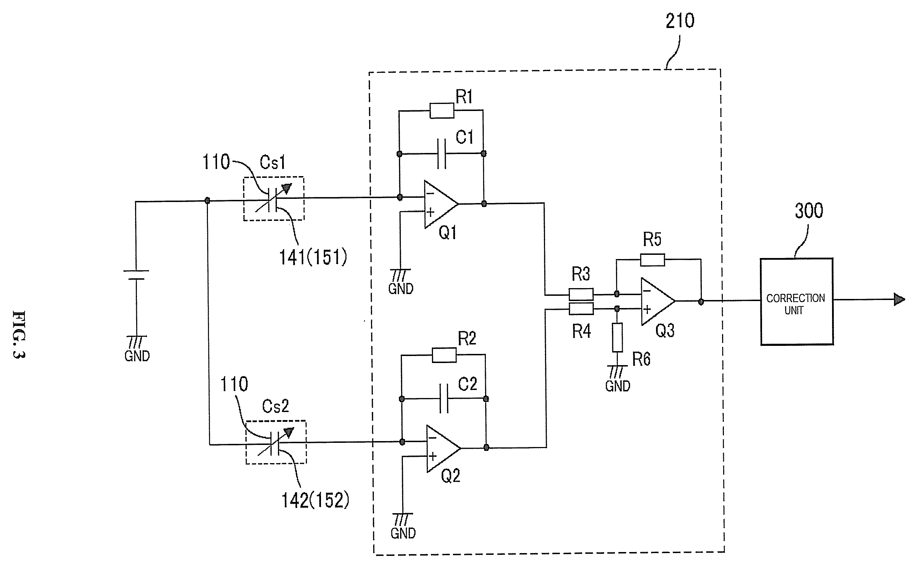

Fig. 3 is a diagram depicting a circuit configuration of a detection unit 210 of the detection unit 200 of the electrostatic capacitance sensor 10. The detection unit 210 is connected to the fixed electrodes 141 and 142. In addition to the detection unit 210, the detection unit 200 also has a circuit that is connected to the fixed electrodes 151 and 152. This circuit also has a same configuration as the detection unit 210.

DC voltage is biased to the movable electrode 110. The fixed electrode 141 is connected to the negative input terminal of the differential amplifier Q1. The positive side input terminal of the differential amplifier Q1 is grounded. A resistor R1 and a capacitor C1 are connected in parallel to the negative side input terminal of the differential amplifier Q1 and the output terminal of the differential amplifier Q1.

The fixed electrode 142 is connected to the negative side input terminal of a differential amplifier Q2. The positive side input terminal of the differential amplifier Q2 is grounded. A resistor R2 and a capacitor C2 are connected in parallel to the negative side input terminal of the differential amplifier Q2 and the output terminal of the differential amplifier Q2.

The output terminal of the differential amplifier Q1 is connected to one input terminal (e.g. negative side input terminal) of a differential amplifier Q3 via a resistor R3, and the output terminal of the differential amplifier Q2 is connected to the other input terminal (e.g. positive side input terminal) of the differential amplifier Q3 via a resistor R4. A resistor R5 is connected in parallel to one input terminal of the differential amplifier Q3 and the output terminal of the differential amplifier Q3. The resistor R4 and the other input terminal of the differential amplifier Q3 are grounded via a resistor R6. The output of the differential amplifier Q3 is inputted to the correction unit 300.

Each circuit of the differential amplifiers Q1 and Q2 is an electric charge-voltage conversion circuit, winch converts the capacitance between the connected electrodes into a voltage signal, and outputs the voltage signal respectively. The circuit of the differential amplifier Q3 is a differential arithmetic circuit, which outputs the differential result of (Q2 - Q1).

In the later mentioned calculation of the theoretical formula, the output is regarded as the capacitance [F] to simplify description. In the actual electrostatic capacitance sensor 10 however, the voltage signals [V] converted by the above mentioned Q1 and Q2 are outputted.

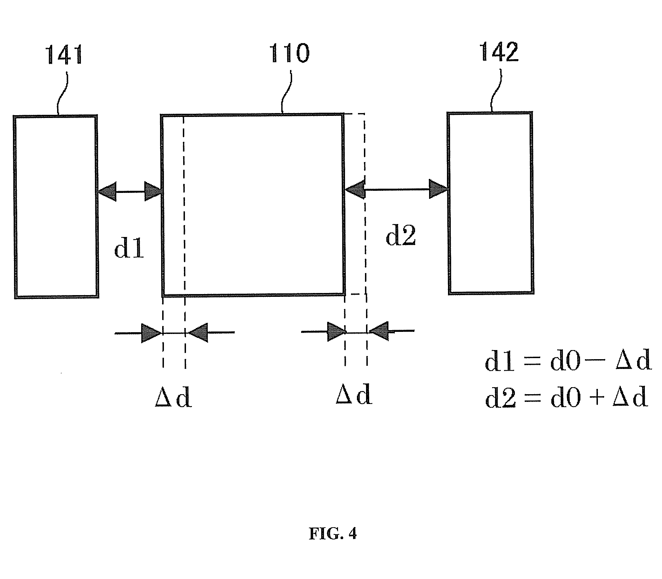

Fig. 4 shows a movement of the movable electrode 110 when acceleration in the X direction shown in Figs. 1 and 2 is applied to the movable electrode 110 of the electrostatic capacitance sensor 10. The initial distance between the movable electrode 110 and the fixed electrodes 141 and 142 (electrode distance when acceleration is 0) is do. If the movable electrode 110 shifts to the left by $\Delta d$, the distance $d_1$ between the movable electrode 110 and the fixed electrode 141 becomes $(d_0 - \Delta d)$, and the distance $d_2$ between the movable electrode 110 and the fixed electrode 142 becomes $(d_0 + \Delta d)$.

The capacitance $C_1$ between the movable electrode 110 and the fixed electrode 141 is determined by Expression (1).

[Math. 1]

$$C_1 = \varepsilon \cdot S_1 \cdot \frac{1}{(d_0 - \Delta d)} \quad [F] \qquad \cdots (1)$$

where $\varepsilon$ denotes a dielectric constant, and $S_1$ denotes an area of a portion where the movable electrode 110 and the fixed electrode 141 face each other.

In the same manner, the capacitance $C_2$ between the movable electrode 110 and the fixed electrode 142 is determined by Expression (2).

[Math. 2]

$$C_2 = \varepsilon \cdot S_2 \cdot \frac{1}{(d_0 + \Delta d)} \quad [F] \qquad \cdots (2)$$

where $S_2$ denotes an area of a portion where the movable electrode 110 and the fixed electrode 142 face each other.

$S_2$ is equal to $S_1$. Therefore the theoretical formula to indicate the output $\Delta C$ from the detection unit 210 in Fig. 3 becomes the difference between Expression (1) and Expression (2) that is Expression (3) shown below.

[Math. 3]

$$\Delta C = \varepsilon \cdot S_1 \cdot \frac{2 \Delta d}{(d_0{}^2 - \Delta d^2)} \quad [F] \qquad \cdots (3)$$

If m denotes the mass of a movable electrode 110 and k denotes a spring constant when four beam members 130 are regarded as one spring, Expression (3) can be transformed as follows using $f = m \cdot a = k \cdot \Delta d$. This expression becomes the theoretical formula to calculate the acceleration a.

[Math. 4]

$$\Delta C = \varepsilon \cdot S_1 \cdot \frac{2 \ ((m/k) \cdot a)}{(d_0{}^2 - ((m/k) \cdot a)^2)} \quad [F] \qquad \cdots (4)$$

If $\alpha_{XY}$: $\varepsilon S1 \cdot 2(k/m)$ and $\beta_{XY}$: $(k/m)^2 \cdot d_0{}^2$, then Expression (4) becomes Expression (5).

[Math. 5]

$$\Delta C = \frac{\alpha_{XY} \cdot a}{(\beta_{XY} - a^2)} \quad [F] \cdots (5)$$

The inversion formula of Expression (5) becomes Expression (6).

[Math. 6]

$$a = \frac{-\alpha_{XY} + \sqrt{(\alpha_{XY}{}^2 + 4\beta_{XY}(\Delta C)^2)}}{2 \cdot \Delta C} \quad [G] \qquad \cdots (6)$$

The correction unit 300 performs correction based on Expression(6) and calculates the first acceleration signal. Concrete values of the coefficients $\alpha_{XY}$ and $\beta_{XY}$ in Expression (6) can be determined using the numerical values of the design values of the electrostatic capacitance sensor 10, such as the numeric value of an area of each electrode, an initial distance do of an electrode, a dielectric constant between electrodes, a mass of a weight, and a spring constant of a beam. For the concrete numeric values of the coefficients $\alpha_{XY}$ and $\beta_{XY}$, the numeric values of the result of the actual measurement of the electrostatic capacitance sensor 10, such as the numeric value of each electrode, an initial distance $d_0$ of an electrode, a dielectric constant between electrodes, a mass of a weight, and a spring constant of a beam may be used. These concrete numeric values may be calculated by adding a predetermined acceleration value (preferably a plurality of acceleration values) to each electrostatic capacitance sensor 10, and fitting the actual measured values of the output from the electrostatic capacitance sensor 10 at this time to Expression (6). For this fitting, the least squares method, for example, may be used. The fitting, however, is not limited to the least squares method. The data of the coefficients $\alpha_{XY}$ and $\beta_{XY}$ is stored in the correction data storage unit 302. And the data stored in the correction data storage unit 302 is rewritable.

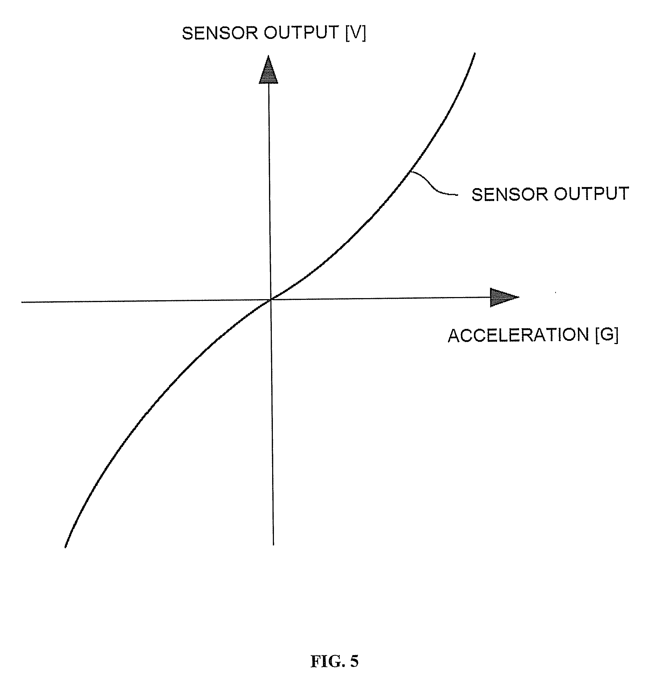

Fig. 5 is a graph showing a relationship between the output ΔC from the detection unit 210 and the acceleration G. As shown in Fig. 5, the relationship between the output ΔC from the detection unit 210 and the acceleration G is non-linear.

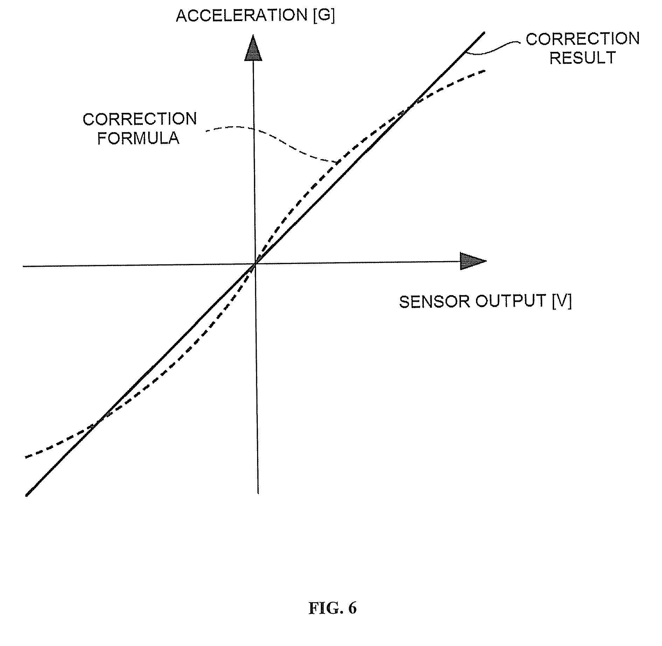

Fig. 6 is a graph showing the correction formula shown in Expression(6), and the output after the output ΔC shown in Fig. 5 is corrected using this correction formula (first acceleration signal). As shown in Fig. 6, the relationship between the output of the correction unit 300 and the acceleration G can be linearized by the correction unit 300 performing correction.

In the example shown in Fig. 6, the correction unit 300 may use mutually different correction methods, depending on whether the acceleration is positive or negative. For example, the above mentioned fitting is performed separately when the acceleration is positive and when the acceleration is negative, whereby mutually different correction methods are set. Then accuracy of the correction of the correction unit 300 improves.

Even if the acceleration in the Y direction shown in Fig. 1 is applied to the movable electrode 110 of the electrostatic capacitance sensor 10, the correction unit 300 performs correction similar to the description in Fig. 4.

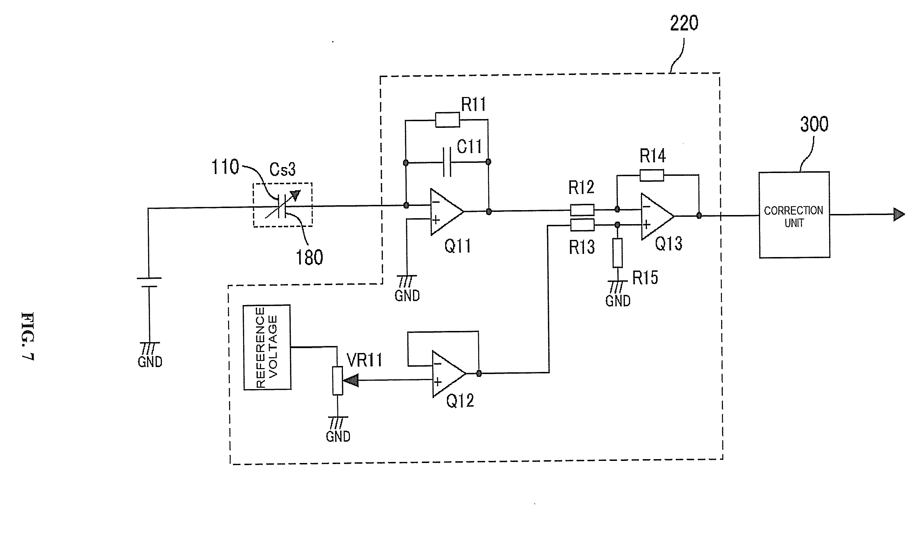

Fig. 7 is a diagram depicting a circuit configuration of a detection unit 220 of the detection unit 200 of the electrostatic capacitance sensor 10. The detection unit 220 is connected to the fixed electrode 180.

As mentioned above, DC voltage is biased to the movable electrode 110. The fixed electrode 180 is connected to the negative side input terminal of the differential amplifier Q11. The positive side input terminal of the differential amplifier Q11 is grounded. A resistor R11 and a capacitor C11 are connected in parallel to the negative side input terminal of the differential amplifier Q11 and the output terminal of the differential amplifier Q11.

The output terminal of the differential amplifier Q11 is connected to one input terminal (e.g. negative side input terminal) of the differential amplifier Q13 via a resistor R12. The output terminal of the differential amplifier Q12 is connected to the other input terminal (e.g. positive side input terminal) of the differential amplifier Q13 via a resistor R13. One input terminal (e.g. negative side input terminal) of the differential amplifier Q12 is connected to the output terminal of the differential amplifier Q12, and reference voltage is applied to the other input terminal (e.g. positive side input terminal) of the differential amplifier Q12 via a variable resistor VR11.

A resistor R14 is connected in parallel to one input terminal of the differential amplifier Q13 and the output terminal of the differential amplifier Q13. The resistor R13 and the other input terminal of the differential amplifier Q13 are grounded via a resistor R15. The output of the differential amplifier Q13 is inputted to the correction unit 300.

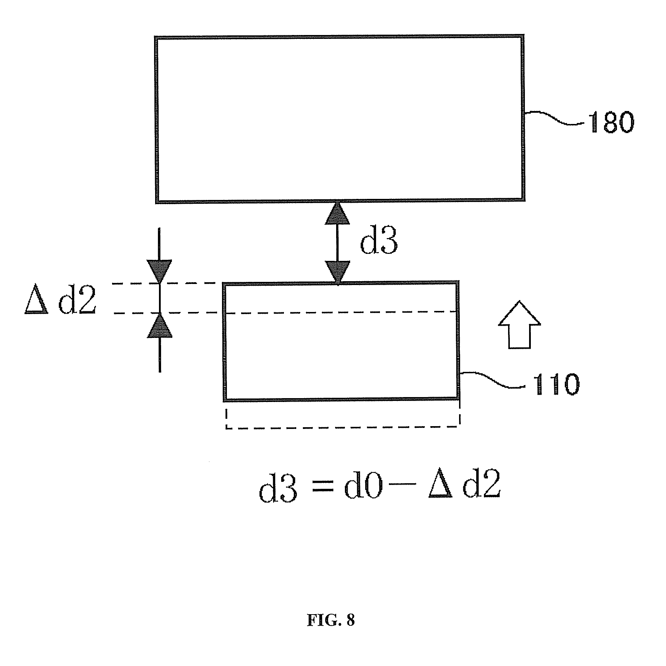

Fig. 8 is a diagram depicting a movement of the movable electrode 110 when acceleration in the Z direction shown in Fig. 2 is applied to the movable electrode 110 of the electrostatic capacitance sensor 10. The initial distance between the movable electrode 110 and the fixed electrode 180 (electrode distance when acceleration is 0) is $d_0$. If the movable electrode 100 up-shifts by $\Delta d_2$, the distances $d_3$ between the movable electrode 110 and the fixed electrode 180 is $(d_0 - \Delta d_2)$.

The capacitance $C_3$ between the movable electrode 110 and the fixed electrode 180 is determined by Expression (7).

[Math. 7]

$$C_3 = \varepsilon \cdot S_3 \cdot \frac{1}{(d_0 - \Delta d_2)} \ [F] \ \cdots \ (7)$$

where ε denotes a dielectric constant and $S_3$ denotes an area of a portion where the movable electrode 110 and the fixed electrode 180 face each other.

The theoretical formula to indicate the output ΔC from the detection unit 220 in Fig. 7 is the following Expression (8).

[Math. 8]

$$\Delta C = \varepsilon \cdot S_3 \cdot \frac{\Delta d_2}{d_0 \cdot (d_0 - \Delta d_2)} \ [F] \ \cdots \ (8)$$

If m denotes a mass of the movable electrode 110 and $k_2$ denotes a spring constant in the Z direction when the four beam members 130 are regarded as one spring, Expression (8) can be transformed as follows using f = m · a = $k_2 \cdot \Delta d_2$. This Expression (9) is the theoretical formula to calculate the acceleration a.

[Math. 9]

$$\Delta C = \varepsilon \cdot S_3 \cdot \frac{(m/k_2) \cdot a}{d_0 \cdot (d_0 - (m/k_2) \cdot a))} \; [F] \quad \cdots \; (9)$$

If $\alpha_z$: $\varepsilon \cdot S_3 \cdot (1/d_0)$ and $\beta_z$: $(k_2/m) \cdot d_0$, then Expression (9) becomes Expression (10).
[Math. 10]

$$\Delta C = \frac{\alpha_z \cdot a}{(\beta_z - a)} \quad [F] \cdots \; (10)$$

The inversion formula of Expression (10) becomes Expression (11).
[Math. 11]

$$a = \frac{\beta_z \cdot \Delta C}{(\alpha_z + \Delta C)} \quad [G] \quad \cdots \; (11)$$

The correction unit 300 performs correction based on Expression (11), and calculates the second acceleration signal. Concrete values of the coefficients $\alpha_z$ and $\beta_z$ in Expression (11) can be determined by a method similar to one used to determine the coefficients $\alpha_{xy}$ and $\beta_{xy}$ described above.

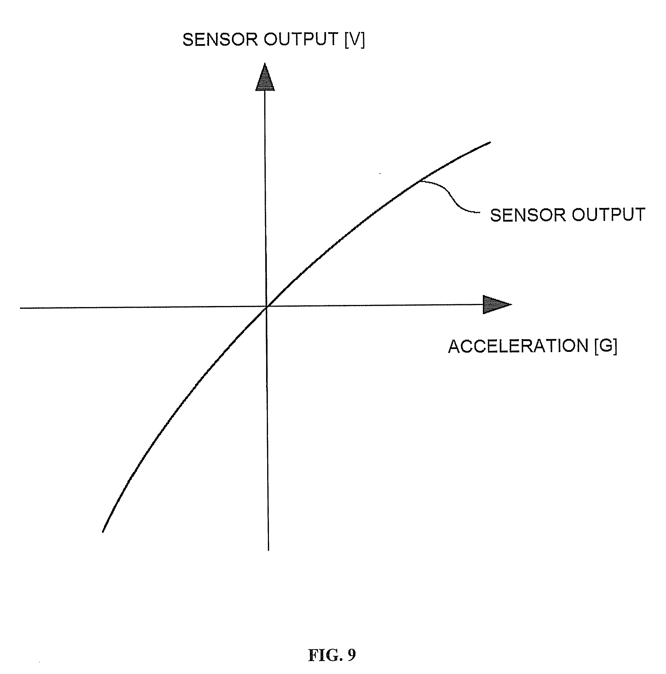

Fig. 9 is a graph showing a relationship between the output $\Delta C$ from the detection unit 220 and the acceleration G. As shown in Fig. 9, the relationship between the output $\Delta C$ from the detection unit 220 and the acceleration G is non-linear.

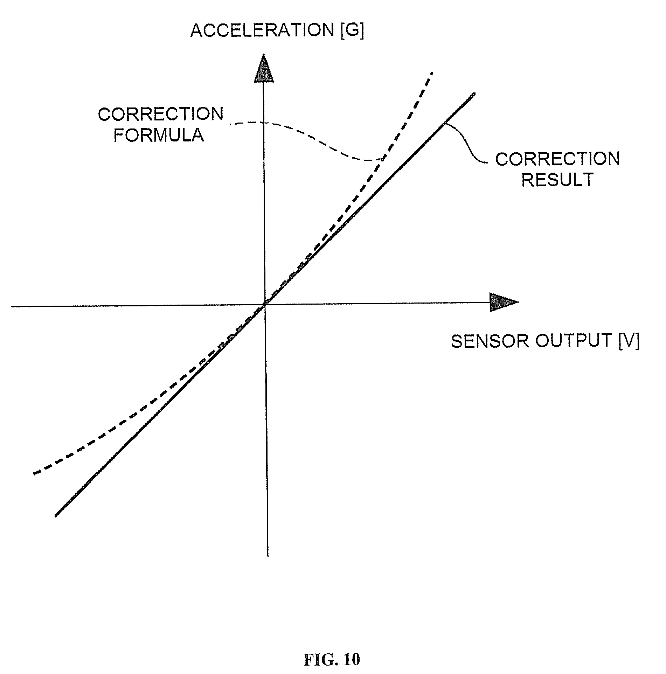

Fig. 10 is a graph showing the correction formula shown in Expression (11), and output after the output $\Delta C$ shown in Fig. 9 is corrected using this correction formula (second acceleration signal). As shown in Fig. 10, the relationship between the output of the correction unit 300 and the acceleration G can be linearized by the correction unit 300 performing correction.

In the example shown in Fig. 10, the correction unit 300 may have a common correction method that is used regardless whether the acceleration is positive or negative. For example, if the above mentioned fitting is performed without separating cases that depend on whether acceleration is positive or negative, a common correction method can be set.

According to this embodiment, the correction unit 300 corrects the output of the detection unit 200. Therefore the acceleration signal outputted by the electrostatic capacitance sensor 10 has high accuracy. Further, according to this embodiment, the correction method used by the correction unit 300 is changed depending on the positional relationship (combination type) between the movable electrode 110 and the fixed electrodes. In concrete terms, a correction method, that the correction unit 300 applies to the output from the fixed electrodes 180 is different from a correction method that the correction unit 300 applies to the output from the fixed electrodes 141 and 142. Therefore the electrostatic capacitance sensor 10 can detect acceleration in a plurality of directions (e.g. X direction, Y direction, Z direction) at high accuracy.

Furthermore, when the correction unit 300 calculates a polygonal line as an approximation of the correction formula by connecting two adjacent points, out of a plurality of points stored in the correction table, with a straight line, arithmetic processing performed by the correction unit 300 can be decreased.

(Embodiment 2)

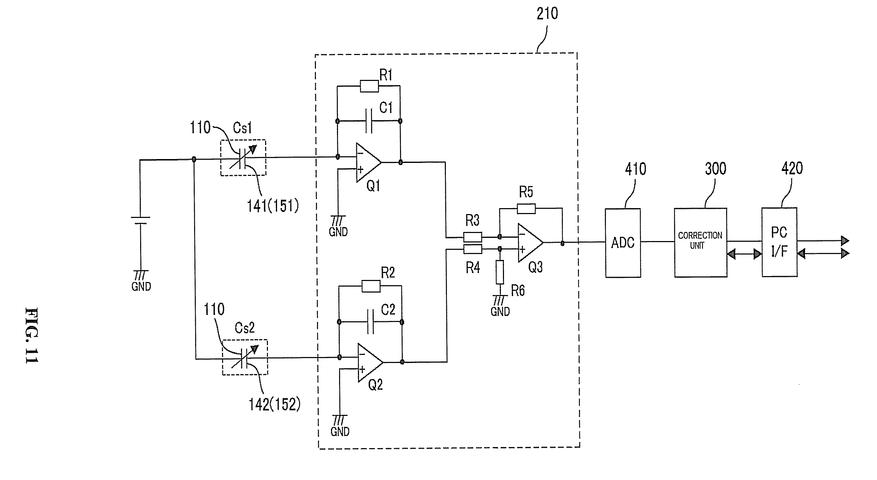

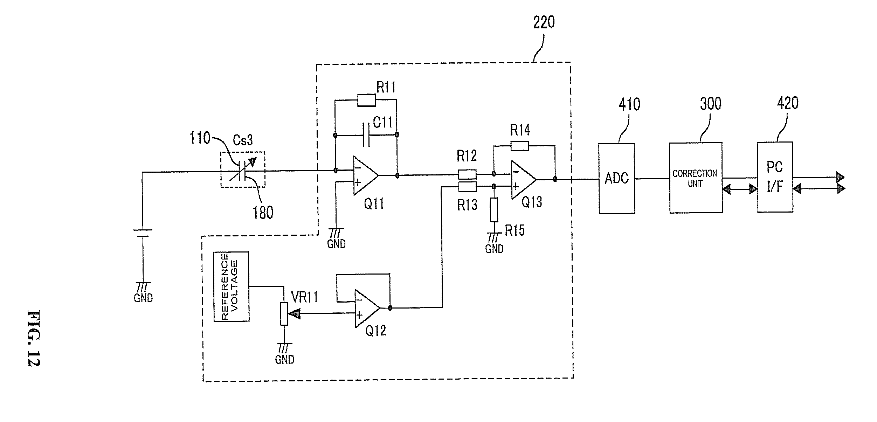

Fig. 11 and Fig. 12 are diagrams depicting the functional configurations of an electrostatic capacitance sensor 10 according to Embodiment 2. Fig. 11 corresponds to Fig. 3 according to Embodiment 1, and Fig. 12 corresponds to Fig. 7 according to Embodiment 1. The electrostatic capacitance sensor 10 according to Embodiment 2 has a configuration similar to that of the electrostatic capacitance sensor 10 according to Embodiment 1, except that in Embodiment 2 an AD conversion unit 410 and an interface 420 are included.

The AD conversion unit 410 is disposed between the detection unit 200 and the correction unit 300, and converts the output (an analog signal) from the detection unit 200 into a digital signal. Then the correction unit 300 performs correction processing by digitally processing the digital signal outputted from the AD conversion unit 410.

The interface 420 is an interface that connects an external apparatus (e.g. computer) of the electrostatic capacitance sensor 10 and the correction unit 300. The information stored in the correction data storage unit 302 of the correction unit 300 is rewritable via this interface 420.

An effect similar to Embodiment 1 can also be obtained by this embodiment. The correction unit 300 performs digital processing, which means that the correction operation of the correction unit 300 can be executed by a software program, for example. The information stored by the correction data storage unit 302 of the correction unit 300 is rewritable via the interface 420, therefore optimum correction data reflecting the individual difference of an electrostatic capacitance sensor 10 can be set for each electrostatic capacitance sensor 10.

(Embodiment 3)

The plan view depicting a configuration of an electrostatic capacitance sensor 10 according to Embodiment 3 is shown in Fig. 1, which is the same as the electrostatic capacitance sensor 10 according to Embodiment 1. In Embodiment 3, just like the case of Embodiment 1, Fig. 2 shows the cross-sectional view at A-A' in Fig. 1. Furthermore, just like Embodiment 1, the circuit configuration of the detection unit 210 and the circuit configuration of the detection unit 220 of the detection unit 200 of the electrostatic capacitance sensor 10 according to Embodiment 3 are shown in Fig. 3 and Fig. 7.

According to the electrostatic capacitance sensor 10 of Embodiment 3, in the initial state, deviations from the design values (offset value) have been generated in the distance between the fixed electrode 141 and the movable electrode 110, and in the distance between the fixed electrode 142 and the movable electrode 110. Here "design values" refers to the distance value between the fixed electrode 141 and the movable electrode 110, and the distance value between the fixed electrode 142 and the movable electrode 110, and these values are both predetermined and the same. In other words, the movable electrode 110 is designed to be located at the center between the fixed electrode 141 and the fixed electrode 142. And "initial state" refers to the state where the acceleration applied to the electrostatic capacitance sensor 10 is 0G. The deviation generated in the initial state is hereafter called "initial deviation". The initial deviation corresponds to a manufacturing error generated in an actual manufactured electrostatic capacitance sensor 10.

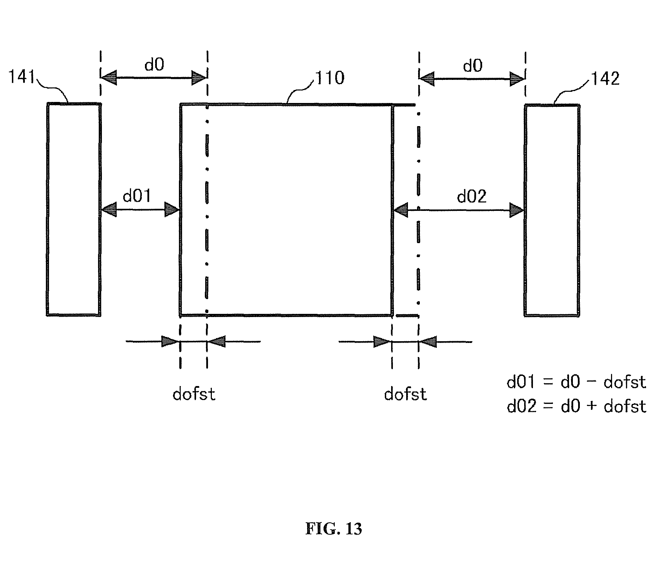

Fig. 13 is a diagram depicting a positional relationship between the fixed electrodes 141 and 142 and the movable electrode 110 in the initial state of the electrostatic capacitance sensor 10 in the X direction in Figs. 1 and 2. In Fig. 13, $d_0$ is a design value of a distance between the fixed electrode 141 and the movable electrode 110, and also a distance value between the fixed electrode 142 and the movable electrode 110. In Fig. 13, $d_{ofst}$ denotes an initial deviation value.

In Fig. 13, the distance $d_{01}$ between the movable electrode 110 and the fixed electrode 141 is $d_0$-$d_{ofst}$. In this case, the capacitance $C_1$ between the movable electrode 110 and the fixed electrode 141 is determined by Expression (12).
[Math. 12]

$$C_1 = \varepsilon \cdot S_1 \cdot \frac{1}{(d_0 - d_{ofst})} \quad [F] \quad \cdots (12)$$

where s denotes a dielectric constant, and $S_1$ denotes an area of a portion where the movable electrode 110 and the fixed electrode 141 face each other.

In Fig. 13, the distance $d_{02}$ between the fixed electrode 142 and the movable electrode 110 is $d_o + d_{ofst}$. Therefore the capacitance $C_2$ between the movable electrode 110 and the fixed electrode 142 is determined by Expression (13).
[Math. 13]

$$C_2 = \varepsilon \cdot S_2 \cdot \frac{1}{(d_0 + d_{ofst})} \quad [F] \quad \cdots (13)$$

where $S_2$ denotes an area of a portion where the movable electrode 110 and the fixed electrode 142 face each other. $S_1$ is equal to $S_2$.

At this time, the theoretical formula to indicate the output from the detection unit 210 in Fig. 3 is expressed as the capacitance difference $Cdif_1$ between Expression (12) and Expression (13). That is, $Cdif_1 = C_{12} = (C_1 - C_2)$. The output of the electrostatic capacitance sensor 10 in the initial state in Fig. 13 has been adjusted in advance to be zero ($C_{12} = 0$).

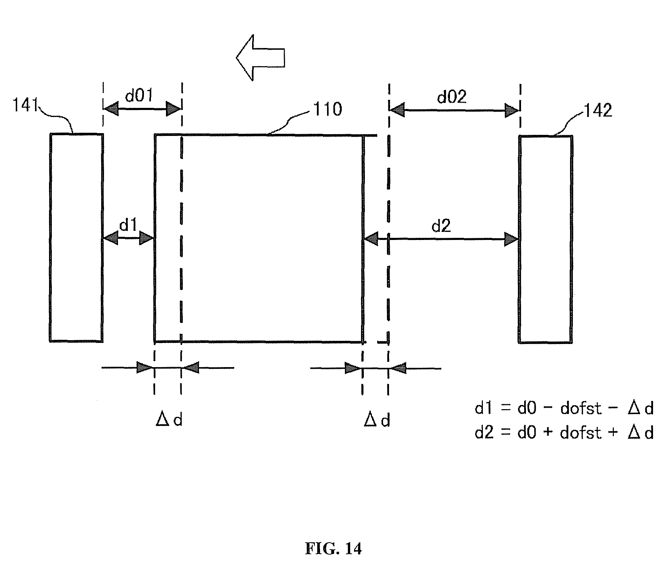

Fig. 14 shows a movement of the movable electrode 110 when acceleration in the X direction shown in Figs. 1 and 2 is applied to the movable electrode 110 of the electrostatic capacitance sensor 10. The initial distance $d_{01}$ between the movable electrode 110 and the fixed electrode 141 is ($d_0 - d_{ofst}$). Therefore if the movable electrode 110 shifts to the left by Δd, the electrode distance $d_1$ becomes ($d_o$- $d_{ofst}$ - Δd). In the same manner, the initial distance $d_{02}$

of the movable electrode 110 and the fixed electrode 142 is $(d_0 + d_{ofst})$. Therefore if the movable electrode 110 shifts to the left by $\Delta d$, the electrode distance $d_2$ becomes $(do + d_{ofst} + \Delta d)$.

In this case, the capacitance $C_3$ between the movable electrode 110 and the fixed electrode 141 is determined by Expression (14).

[Math. 14]

$$C_3 = \varepsilon \cdot S_1 \cdot \frac{1}{(d_0 - d_{ofst} - \Delta d)} \quad [F] \cdots (14)$$

In this case as well, the capacitance $C_4$ between the movable electrode 110 and the fixed electrode 142 is determined by Expression (15).

[Math. 15]

$$C_4 = \varepsilon \cdot S_2 \cdot \frac{1}{(d_0 + d_{ofst} + \Delta d)} \quad [F] \cdots (15)$$

At this time, the theoretical formula to indicate the output from the detection unit 210 in Fig. 3 is expressed as the capacitance difference $Cdif_2$ between Expression (14) and Expression (15). That is, $Cdif_2 = C_{34} = (C_3 - C_4)$.

The output $\Delta C$ of the electrostatic capacitance sensor 10 in Fig. 14 is a difference between the capacitance differences $Cdif_2$ and $Cdif_1$ of the movable electrode 110 before and after a shift respectively, therefore $\Delta C = (Cdif_2 - Cdif_1) = (C_{34} - C_{12})$. Hence $\Delta C$ is determined by Expression (16). In Expression (16), $S_1 = S_2 = S$.

[Math. 16]

$$\begin{aligned}
\Delta C &= Cdif_2 - Cdif_1 \\
&= C_{34} - C_{12} \\
&= (C_3 - C_4) - (C_1 - C_2) \\
&= C_3 - C_4 - C_1 + C_2 \\
&= \varepsilon \cdot S \cdot \left( \frac{1}{(d_0 - d_{ofst} - \Delta d)} - \frac{1}{(d_0 + d_{ofst} + \Delta d)} - \frac{1}{(d_0 - d_{ofst})} + \frac{1}{(d_0 + d_{ofst})} \right) \\
&= \varepsilon \cdot S \cdot \left\{ \left( \frac{1}{(d_0 - d_{ofst} - \Delta d)} - \frac{1}{(d_0 - d_{ofst})} \right) - \left( \frac{1}{(d_0 + d_{ofst} + \Delta d)} - \frac{1}{(d_0 + d_{ofst})} \right) \right\} \\
&= \varepsilon \cdot S \cdot \left( \frac{\Delta d}{(d_0 - d_{ofst} - \Delta d)(d_0 - d_{ofst})} + \frac{\Delta d}{(d_0 + d_{ofst} + \Delta d)(d_0 + d_{ofst})} \right) \quad [F] \quad \cdots (16)
\end{aligned}$$

If m denotes a mass of the movable electrode 110 and k denotes a spring constant when the four beam members 130 are regarded as one spring, Expression (16) can be transformed as shown in Expression (17) using $f = m \cdot a = k \cdot \Delta d$. This Expression (17) becomes the theoretical formula to calculate the acceleration a.

[Math. 17]

$$\Delta C = \varepsilon \cdot S \cdot \left( \frac{(m/k) \cdot a}{(d_0 - d_{ofst} - (m/k) \cdot a)(d_0 - d_{ofst})} \right.$$

$$\left. + \frac{(m/k) \cdot a}{(d_0 + d_{ofst} + (m/k) \cdot a)(d_0 + d_{ofst})} \right) \quad [F] \cdots (17)$$

If $\alpha_{XY}$: $\varepsilon S/(d_0-d_{ofst})$, $\beta_{XY}$: (k/m) • ($d_0 + d_{ofst}$), and $\gamma_{XY}$: ($d_0 - d_{ofst}$)/($d_0 + d_{ofst}$), then Expression (17) can be transformed into Expression (18).
[Math. 18]

$$\Delta C = \frac{\alpha_{XY} \cdot a}{\beta_{XY} \cdot \gamma_{XY} - a} + \frac{\alpha_{XY} \cdot \gamma_{XY} \cdot a}{\beta_{XY} + a} \quad [F] \cdots (18)$$

The inversion formula of Expression (18) becomes Expression (19).
[Math. 19]

$$a = \frac{-BB - \sqrt{(BB^2 - 4 \cdot AA \cdot CC)}}{2 \cdot AA} \quad [G] \cdots (19)$$

where AA: $\alpha_{XY} • \gamma_{XY} - \alpha_{XY} - \Delta C$, BB: $\beta_{XY} • \gamma_{XY} • \Delta C - \beta_{XY} • AC - \alpha_{XY} • \beta_{XY} - \alpha_{XY} • \beta_{XY} • \gamma_{XY}^2$, CC: $\beta_{XY}^2 • \gamma_{XY} • \Delta C$.

The correction unit 300 of Embodiment 3 performs correction based on Expression (19), and calculates the first acceleration signal. Concrete values of the coefficients $\alpha_{XY}$, $\beta_{XY}$ and $\gamma_{XY}$ in Expression (19) can be determined using the numerical values of the electrostatic capacitance sensor 10, such as values of an area of each electrode, an initial distance $d_0$ of the electrode, an initial deviation $d_{ofst}$ of the electrode, a dielectric constant between electrode, a mass of the movable electrodes, and a spring constant of the beam. These values may be design values or actual measured values. Values calculated by a predetermined method may be used instead. The predetermined method to calculate these values here is, for example, a method of "applying a predetermined acceleration (preferably a plurality of accelerations) to the electrostatic capacitance sensor 10, and fitting the actual measured value of the output from the electrostatic capacitance sensor 10 at this time to Expression (19)". For this fitting, the least squares method, for example, may be used. The fitting however is not limited to the least squares method. The data on coefficients $\alpha_{xy}$, $\beta_{xy}$ and $\gamma_{xy}$ is stored in the correction data storage unit 302. The data stored in the correction data storage unit 302 is rewritable.

Even if the acceleration is applied to the movable electrode 110 of the electrostatic capacitance sensor 10 in the Y direction in Fig. 1, the correction unit 300 performs correction of which content is similar to that described with reference to Fig. 13 and Fig. 14.

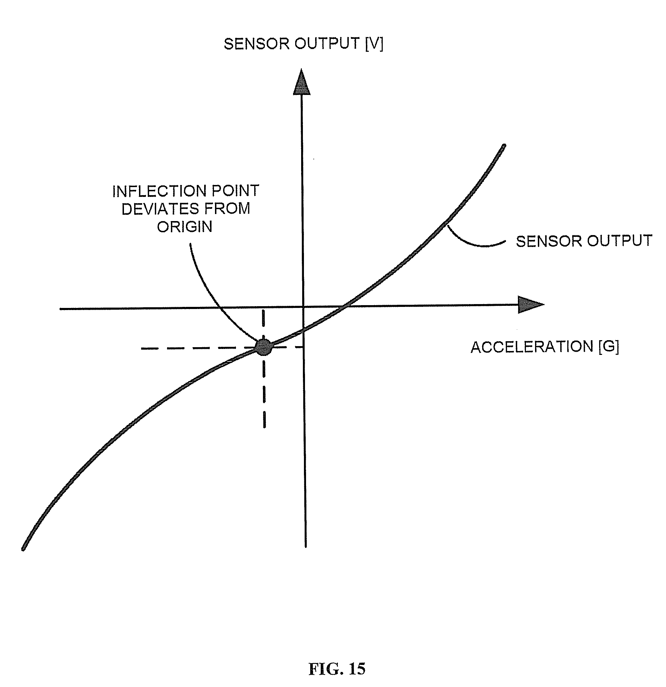

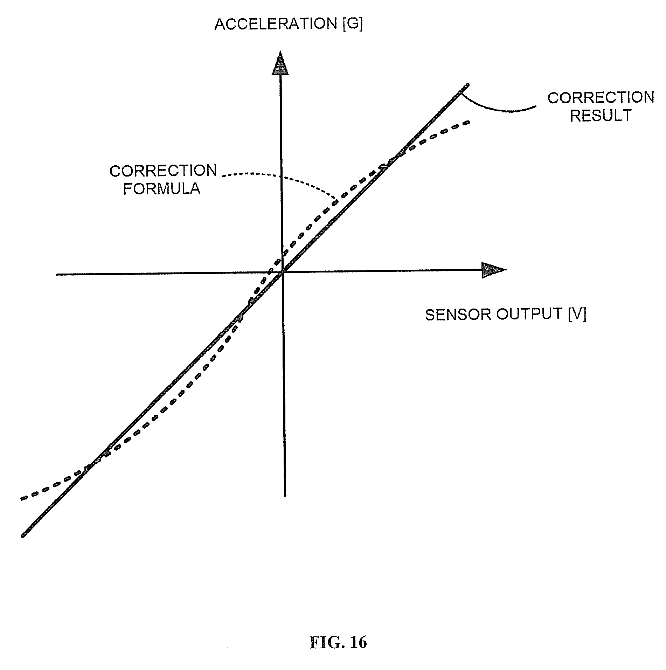

The relationship between the output $\Delta C$ and the acceleration G (X direction or Y direction) when the correction unit 300 of Embodiment 3 does not perform correction is shown in Fig. 15. The relationship between the output $\Delta C$ and the acceleration G when the correction unit 300 performs correction based on Expression (19) is shown in Fig. 16. Since Fig. 15 and Fig. 16 include the initial deviation $d_{ofst}$ of the electrodes, the inflection point deviates from the origin compared with Fig. 5 and Fig. 6 in Embodiment 1. However if the correction unit 300 of Embodiment 3 performs correction based on Expression (19), the relationship between the output $\Delta C$ and the acceleration G of the correction unit 300 can be linearized even if the inflection point deviates from the origin.

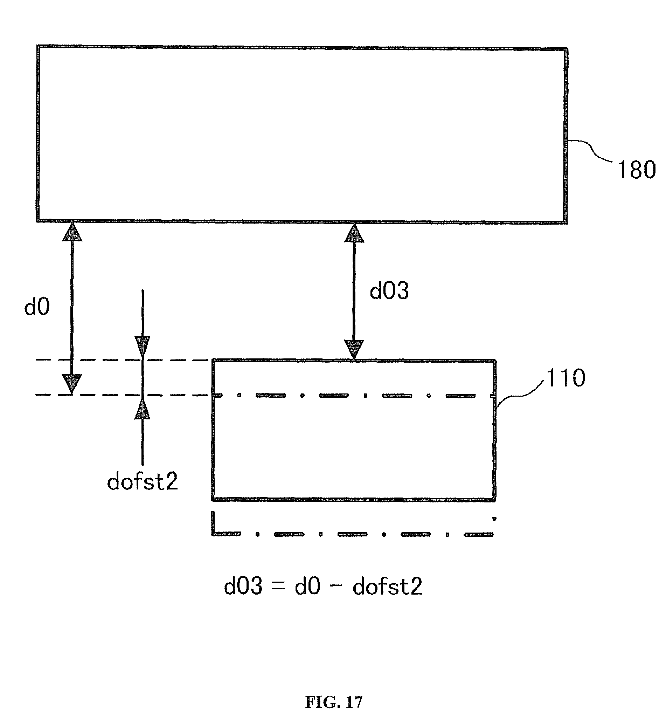

Fig. 17 is a diagram depicting a positional relationship between the movable electrode 110 and the fixed electrode 180 in the initial state of the electrostatic capacitance sensor 10 in the Z direction shown in Fig. 2. According to the electrostatic capacitance sensor 10 of Embodiment 3 in the initial state, an initial deviation $d_{ofst2}$ (offset value) from a predetermined design value has been generated in the distance between the movable electrode 110 and the fixed electrode 180. Therefore in Fig. 17, the distance $d_{03}$ between the movable electrode 110 and the fixed electrode 180 is given by $d_{03} = (d_0 - d_{ofst2})$. Here do is a design value of the distance between the movable electrode 110 and the fixed electrode 180. The initial deviation value $d_{ofst2}$ corresponds to a manufacturing error that is generated in an actual manufactured electrostatic capacitance sensor 10.

In this case, the capacitance $C_5$ between the movable electrode 110 and the fixed electrode 180 is determined by Expression (20).
[Math. 20]

$$C_5 = \varepsilon \cdot S_3 \cdot \frac{1}{(d_0 - d_{ofst2})} \quad [F] \cdots (20)$$

where s denotes a dielectric constant, and $S_3$ denotes an area of a portion where the movable electrode 110 and the fixed electrode 180 face each other.

Just like the above mentioned case of X direction and Y direction, the output of the electrostatic capacitance sensor 10 in the initial state in Fig. 17 has been adjusted in advance to be zero ($C_5 = 0$).

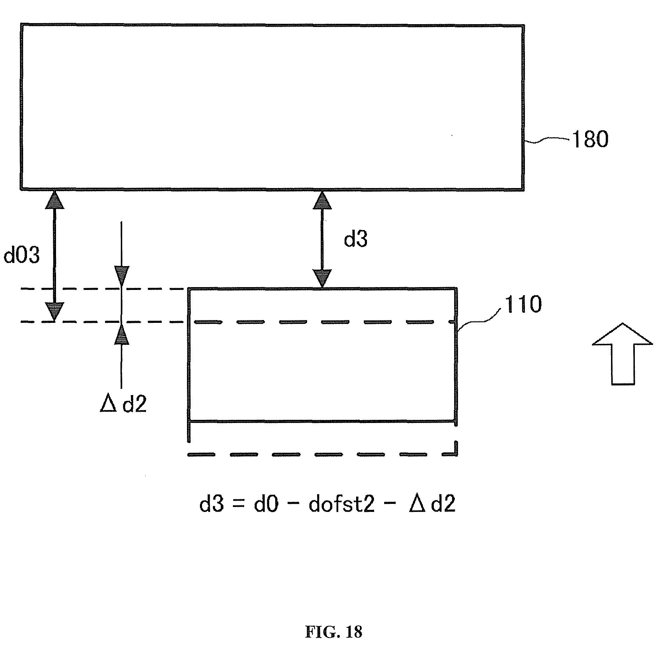

Fig. 18 is a diagram depicting a movement of the movable electrode 110 when acceleration in the Z direction shown in Fig. 2 is applied to the movable electrode 110 of the electrostatic capacitance sensor 10. Here it is assumed that the movable electrode 110 up-shifts by $\Delta d_2$. Since the initial distance $d_{03}$ between the movable electrode 110 and the fixed electrode 180 is ($d_0 - d_{ofst2}$), the electrode distance $d_3$, when the movable electrode 110 up-shifts by $\Delta d_2$ is ($d_0 - d_{ofst2} - \Delta d_2$).

The capacitance $C_6$ between the movable electrode 110 and the fixed electrode 180 is determined by Expression (21).

[Math. 21]

$$C_6 = \varepsilon \cdot S_3 \cdot \frac{1}{d_0 - d_{ofst2} - \Delta d_2} \ [F] \ \cdots (21)$$

The theoretical formula to indicate the output $\Delta C$ from the detection unit 220 in Fig. 7 is $\Delta C = (C_6 - C_5)$, which is the difference of the capacitance of the movable electrode 110 between before and after the shift. $\Delta C$ is determined by Expression (22).

[Math. 22]

$$\Delta C = C_6 - C_5$$
$$= \varepsilon \cdot S_3 \cdot \left( \frac{1}{(d_0 - d_{ofst2} - \Delta d_2)} - \frac{1}{(d_0 - d_{ofst2})} \right)$$
$$= \varepsilon \cdot S_3 \cdot \frac{\Delta d_2}{(d_0 - d_{ofst2} - \Delta d_2)(d_0 - d_{ofst2})} \ [F] \ \cdots (22)$$

If m denotes a mass of a movable electrode 110 and $k_2$ denotes a spring constant in the Z direction when the four beam members 130 are regarded as one spring, Expression (22) can be transformed into Expression (23) using $f = m \cdot a = k \cdot \Delta d_2$. This Expression (23) is the theoretical formula to calculate the acceleration a.

[Math. 23]

$$\Delta C = \varepsilon \cdot S_3 \cdot \frac{(m/k_2) \cdot a}{(d_0 - d_{ofst2} - (m/k_2) \cdot a)(d_0 - d_{ofst2})} \ [F] \ \cdots (23)$$

If $\alpha_z$: $\varepsilon \cdot S_3/(d_0 - d_{ofst2})$ and $\beta_z$: $(k_2/m) \cdot (d_0 - d_{ofst2})$, then Expression (23) can be transformed into Expression (24).

[Math. 24]

$$\Delta C = \frac{\alpha_z \cdot a}{(\beta_z - a)} \ [F] \ \cdots (24)$$

The inversion formula of Expression (24) is given by Expression (25).

[Math. 25]

$$a = \frac{\beta_z \cdot \Delta C}{(\alpha_z + \Delta C)} \ [G] \ \cdots (25)$$

The correction unit 300 performs correction based on Expression (25), and calculates the second acceleration signal. Concrete values of the coefficients $\alpha_z$ and $\beta_z$ in Expression (25) can be determined by a method similar to the one for determining the coefficients $\alpha_{XY}$, $\beta_{XY}$ and $\gamma_{XY}$ of Expression (19).

The relationship between the output $\Delta C$ and the acceleration G (Z direction), when the correction unit 300 of Embodiment 3 does not perform correction as shown in Fig. 9, is just like the case of Embodiment 1. The relationship between the output $\Delta C$ and the acceleration G when the correction unit 300 performs correction based on Expression (25) is shown in Fig. 10, just like the case when the correction unit 300 performs correction in Embodiment 1.

According to the correction unit 300 of this embodiment, even if the initial deviation from the design value (manufacturing error) is generated in the distance between the fixed electrode 141 and the movable electrode 110 and the distance between the fixed electrode 142 and the movable electrode 110, the output from the detection unit 200 is corrected considering this initial deviation. Similarly, according to the correction unit 300 of this embodiment, even if the initial deviation from the design value (manufacturing error) is generated in the distance between the fixed electrode 180 and the movable electrode 110 and the distance between the fixed electrode 142 and the movable electrode 110, the output from the detection unit 200 is corrected considering this initial deviation. Therefore even if such an initial deviation from the design value (manufacturing error) is generated in the electrostatic capacitance sensor 10, an effect similar to the correction unit 300 of Embodiment 1 has been obtained.

(Embodiment 4)

Embodiment 4 shows a method of determining a theoretical formula to indicate an output $\Delta C$ in the X direction (or Y direction) based on a concept (approach) different from Embodiment 3.

A correction unit 300 of Embodiment 4 corrects the output $\Delta C$ when acceleration in the X direction (or Y direction) shown in Figs. 1 and 2 is applied to the movable electrode 110 of the electrostatic capacitance sensor 10, using the theoretical formula determined based on a concept that is different from the theoretical formula used by the correction unit 300 of Embodiment 3.

As mentioned above, Fig. 5 is a graph showing the relationship between the output $\Delta C$ from the detection unit 210 and the acceleration G (in X direction or Y direction). Fig. 5 shows the relationship between the output $\Delta C$ and the acceleration G when the initial deviation from the design value in Fig. 13 is $d_{ofst} = 0$, and has a curved-shape that is symmetric with respect to the origin as the center. The inflection point thereof matches with the origin.

The output $\Delta C$ when the initial deviation is $d_{ofst} = 0$ can be determined by fitting $d_{ofst} = 0$ in Expression (17).
[Math. 26]

$$\Delta C = \varepsilon \cdot S \cdot \frac{2 \cdot (m/k) \cdot a}{(d_0{}^2 - ((m/k) \cdot a)^2)} \quad [F] \quad \cdots (26)$$

If $\alpha_{XY}$: s $\cdot$ S $\cdot$ 2 (k/m) and $\beta_{XY}$: $(k/m)^2 \cdot d_0{}^2$, then Expression (26) can be transformed into Expression (27).
[Math. 27]

$$\Delta C = \frac{\alpha_{XY} \cdot a}{(\beta_{XY} - a^2)} \quad [F] \quad \cdots (27)$$

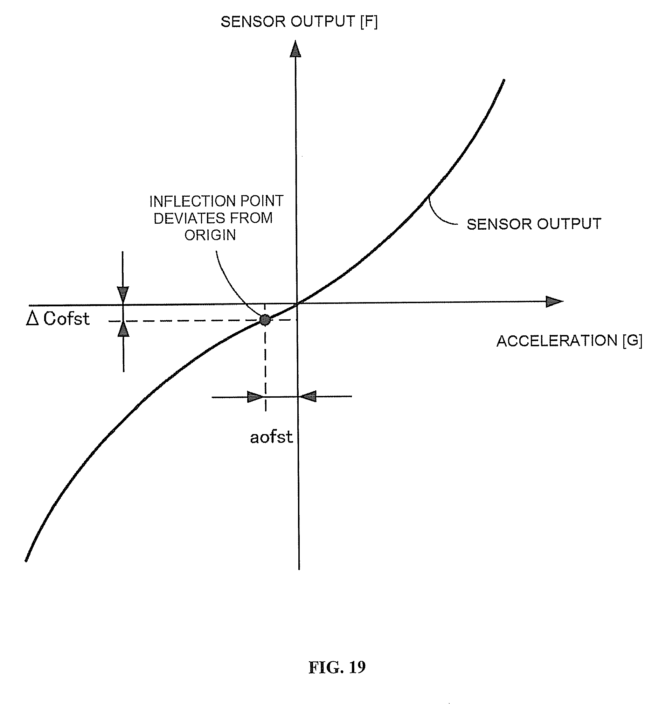

Fig. 19 is a graph showing the relationship between the output $\Delta C$ and the acceleration G when the initial offset is $d_{ofst} \neq 0$ in Fig. 13. In Fig. 19, the inflection point of the graph deviates from the origin due to the initial deviation $d_{ofst}$. Here the deviation of the acceleration a from the origin (hereafter called "deviation of acceleration") is denoted by $a_{ofst}$, and deviation of the output $\Delta C$ from the origin (hereafter called "deviation of output") is denoted by $\Delta C_{ofst}$.

In this case, the theoretical formula to calculate the acceleration a can be determined considering the deviation of the acceleration $a_{ofst}$ and the deviation of the output $\Delta C_{ofst}$. The relationship between the output $\Delta C$ and the acceleration a when the deviation of the acceleration is $a_{ofst}$ and the deviation of the output is $\Delta C_{ofst}$ can be given by Expression (28), applying the deviation of the acceleration $a_{ofst}$ and the deviation of the output $\Delta C_{ofst}$ to Expression (27).
[Math 28]

$$\Delta C - \Delta C_{ofst} = \frac{\alpha_{XY} \cdot (a - a_{ofst})}{(\beta_{XY} - (a - a_{ofst})^2)} \quad [F] \quad \cdots (28)$$

The deviation of output $\Delta C_{ofst}$ can be given by Expression (29).
[Math. 29]

$$\Delta C_{ofst} = \frac{\alpha_{XY} \cdot a_{ofst}}{(\beta_{XY} - a_{ofst}{}^2)} \; [F] \cdots (29)$$

By substituting the right side of Expression (29) for $\Delta C_{ofst}$ of Expression (28), the output $\Delta C$ can be given by Expression (30).
[Math. 30]

$$\Delta C = \frac{\alpha_{XY} \cdot (a - a_{ofst})}{(\beta_{XY} - (a - a_{ofst})^2)} + \frac{\alpha_{XY} \cdot a_{ofst}}{(\beta_{XY} - a_{ofst}{}^2)} \; [F] \cdots (30)$$

If $a_{ofst}$ is substituted by $\gamma_{XY}$ in Expression (30), Expression (31) is obtained.
[Math. 31]

$$\Delta C = \frac{\alpha_{XY} \cdot (a - \gamma_{XY})}{(\beta_{XY} - (a - \gamma_{XY})^2)} + \frac{\alpha_{XY} \cdot \gamma_{XY}}{(\beta_{XY} - \gamma_{XY}{}^2)} \; [F] \cdots (31)$$

Finally, the inversion formula of Expression (31) is determined, whereby the theoretical formula to calculate the acceleration a can be determined, as shown in Expression (32).
[Math. 32]

$$a = \frac{-BB - \sqrt{(BB^2 - 4 \cdot AA \cdot CC)}}{2 \cdot AA} \; [G] \cdots (32)$$

where AA: $-\beta_{XY} \cdot \Delta C + A_{XY}{}^2 \cdot \Delta C + \alpha_{XY} \cdot \gamma_{XY}$, BB: $2\beta_{XY} \cdot \gamma_{XY} \cdot \Delta C - 2\gamma_{XY}{}^3 \cdot \Delta C - \alpha_{XY} \cdot \beta_{XY} - \alpha_{XY} \cdot \gamma_{XY}{}^2$, CC: $\beta_{XY}{}^2 \cdot \Delta C - 2\beta_{XY} \cdot \gamma_{XY}{}^2 \cdot \Delta C + \gamma_{XY}{}^4 \cdot \Delta C$

The correction unit 300 of Embodiment 4 performs the correction based on Expression (32), and calculates a first acceleration signal. Concrete values of the coefficients $\alpha_{XY}$, $\beta_{XY}$ and $\gamma_{XY}$ of Expression (32) can be determined by a method similar to determine the coefficients $\alpha_{XY}$, $\beta_{XY}$ and $\gamma_{XY}$ of Expression (19) described above.

(Embodiment 5)

Embodiment 5 shows a method of determining the coefficients of the theoretical formula (inversion formula) of the acceleration a, which the correction unit 300 uses for correction.

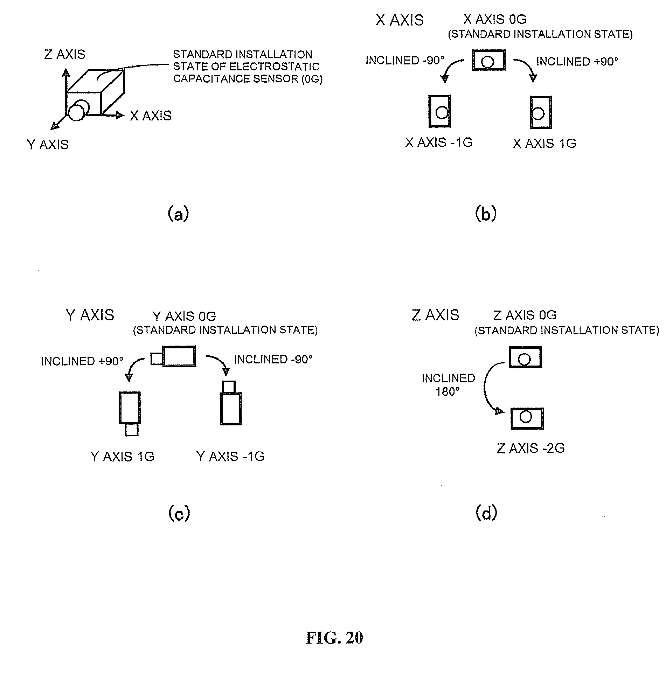

Fig. 20 shows diagrams depicting a range of acceleration that can be applied, using gravitational acceleration, to a housing of the electrostatic capacitance sensor 10. Here Fig. 20A shows a standard installation state. It is assumed that in the case of the standard installation state, acceleration that is applied to the housing of the electrostatic capacitance sensor 10 is 0G in all directions of the X axis, Y axis and Z axis.
Fig. 20B is a diagram depicting a state where the housing is inclined and acceleration is applied in the X axis direction of the housing. The range of the acceleration that is applied in the X axis direction of the housing is a range of acceleration that is applied when the housing is inclined -90° to +90° from the Y axis. If the housing is inclined -90° from the Y axis, acceleration of -1G is applied in the X axis direction of the case. If the case is inclined +90° from the Y axis, acceleration of +1G is applied in the X axis direction of the housing. This means that the range of acceleration that is applied in the X axis direction of the housing, due to the gravitational acceleration, is -1G to + 1 G.
Fig. 20C is a diagram depicting a state where the housing is inclined and acceleration is applied in the Y axis direction of the housing. The range of acceleration that is applied in the Y axis direction of the housing is a range of acceleration that is applied when the housing is inclined -90° to +90° from the X axis. If the housing is inclined -90° from the X axis, acceleration of -1G is applied in the Y axis direction of the housing. If the housing is inclined +90° from the X axis, acceleration of +1G is applied in the Y axis direction of the housing. This means that the range of acceleration that is applied in the Y axis direction of the housing, due to the gravitational acceleration, is -1G to +1G.
Fig. 20D is a diagram depicting a state where the housing is inclined and acceleration is applied in the Z axis direction of the housing. The range of the acceleration that is applied in the Z direction of the housing is a range of acceleration that is applied when the housing is inclined 0° to 180° from the Y axis. If the housing is inclined 180° from the Y axis, acceleration of -2G is applied in the Z axis direction of the housing. If the housing is inclined 0° from the Y axis, this is the standard installation state, an acceleration of 0G is applied in the Z axis direction. This means that the range of acceleration that is applied in the Z axis direction of the housing, due to the gravitational acceleration, is -2G to 0G.

As described above, the ranges of acceleration that is applied in the X direction, the Y direction and the Z direction of the housing are -1G to +1G, -1G to +1G and -2G to 0G respectively.

Here in order to determine the coefficients $\alpha_{XY}$, $\beta_{XY}$, $\gamma_{XY}$, $\alpha_Z$ and $\beta_Z$ in the above mentioned theoretical formula of the acceleration a, an actual measured value of acceleration that is applied using the gravitational acceleration is obtained, and fitting to the theoretical formula is performed using the actual measured value. In this case, the housing is installed on a base that is inclined at a predetermined angle, so that a desired acceleration within the above mentioned range is applied to the housing and the sensor output in this case is measured. By performing the fitting to the theoretical formula using the actual measured value of the acceleration that is measured utilizing gravitational acceleration in this way, the measurement can be more simplified compared with the case of utilizing a vibration generator. As a result, the coefficients of the theoretical formula of the acceleration a can be easily determined.

When the fitting is performed for the X direction (or Y direction) in Fig. 1, it is preferable to measure the sensor output with changing the setting state of the housing, so that the range of the acceleration applied to the housing extends from a positive value to a negative value. This is because an inflection point exists in the change of the sensor output, as shown in Fig. 5, Fig. 15 and Fig. 19. If acceleration is applied to the housing to have a good balance between both positive and negative values, then each coefficient of the theoretical formula of the acceleration a can be accurately determined even when the initial deviation from the design value is generated in the distance between the movable electrode 110 and the fixed electrodes 141 and 142 (or the fixed electrodes 151 and 152).

When the fitting is performed for the Z direction in Fig. 2, on the other hand, the range of the acceleration that is applied to the housing may be only positive or only negative. This is because an inflection point does not exist in the change of the sensor output, as shown in Fig. 9, and each coefficient of the theoretical formula of the acceleration a can be accurately determined only by applying acceleration to the housing in either the positive or negative range, and performing the measurement.

To perform measurement on the electrostatic capacitance sensor 10, it is preferable to measure the gravitational acceleration of the measurement location in advance using a calibrated measuring instrument, and to determine the reference acceleration based on the result of measuring the gravitational acceleration. By considering the characteristics at the measurement location like this, a highly accurate measurement can be performed, and as a result, each coefficient of the theoretical formula of the acceleration a can be accurately determined.

However in the case of using a vibration generator, instead of using gravitational acceleration, as mentioned above, the acceleration range to obtain the actual measurement result is not limited to the above mentioned range. If the vibration generator is used, measurement results in both positive and negative acceleration ranges are inevitably obtained, hence these results can be directly used for fitting.

Embodiments of the present invention have been described with reference to the drawings, but these are examples of the present invention, and various other configurations may be used.

The present application claims priority from Japanese Patent Application No. 2013-077145 filed on April 2, 2013, and the entire contents of which are hereby incorporated.

**Claims**

1. An electrostatic capacitance sensor, comprising:

   a movable electrode;
   a support;
   a beam member that attaches the movable electrode to the support in a movable state;
   a first fixed electrode that faces the movable electrode from a first direction;
   a second fixed electrode that faces the movable electrode from a second direction which is different from the first direction;
   a detection unit that detects a change of capacitance charged between the movable electrode and each of the fixed electrodes; and
   a correction unit that corrects a detection result of the detection unit, and generates an acceleration signal which indicates acceleration.

2. The electrostatic capacitance sensor according to Claim 1, wherein
   there is a plurality of types of combinations between the fixed electrode and the movable electrode, and

the correction unit performs the correction for each type of combination on the basis of a correction method which is different for the each type.

3. The electrostatic capacitance sensor according to Claim 2, further comprising a third fixed electrode that faces the first fixed electrode from the first direction via the movable electrode, wherein
the detection unit detects first capacitance that is generated between the movable electrode and the first fixed electrode, second capacitance that is generated between the movable electrode and the second fixed electrode, and third capacitance charged between the movable electrode and the third fixed electrode,
the correction unit calculates a first acceleration signal which indicates acceleration in the first direction using the first capacitance and the third capacitance, and calculates a second acceleration signal which indicates acceleration in the second direction using the second capacitance, and
the correction method used to calculate the second acceleration signal is different from the correction method used to calculate the first acceleration signal.

4. The electrostatic capacitance sensor according to Claim 3, wherein
the first fixed electrode and the third fixed electrode face an edge of the movable electrode, and
the second fixed electrode faces a front face or a rear face of the movable electrode.

5. The electrostatic capacitance sensor according to any one of Claims 1 to 4, wherein
the correction unit stores a correction table, and generates the acceleration signal based on a correction formula using the correction table.

6. The electrostatic capacitance sensor according to Claim 5, wherein the correction table is rewritable.

7. A method for correcting non-linear output in an electrostatic capacitance sensor, including:

   a movable electrode;
   a support;
   a beam member that attaches the movable electrode to the support in a movable state;
   a first fixed electrode that faces the movable electrode from a first direction;
   a second fixed electrode that faces the movable electrode from a second direction which is different from the first direction;
   a detection unit that detects a change of capacitance charged between the movable electrode and each of the fixed electrodes; and
   a correction unit that corrects non-linear output with respect to acceleration detected by the detection unit to be linear output with respect to the acceleration, and generates an acceleration signal which indicates the acceleration corresponding to the output after the correction,
   the method comprising:

      calculating a theoretical formula to calculate capacitance from acceleration, using distances between the movable electrode and the fixed electrodes and a spring constant of the beam member; and
      correcting the output of the detection unit, using an inversion formula of the theoretical formula.

8. The method for correcting non-linear output according to Claim 7, wherein
the theoretical formula is calculated using deviations of distances between the movable electrode and the fixed electrodes from design values.

9. The method for correcting non-linear output according to Claim 7, wherein
the electrostatic capacitance sensor further includes a third fixed electrode that faces the first fixed electrode from the first direction via the movable electrode,
the detection unit of the electrostatic capacitance sensor detects first capacitance that is generated between the movable electrode and the first fixed electrode, second capacitance that is generated between the movable electrode and the second fixed electrode, and third capacitance that is generated between the movable electrode and the third fixed electrode, and
the correction unit of the electrostatic capacitance sensor calculates a first acceleration signal which indicates acceleration in the first direction using the first capacitance and the third capacitance, and calculates a second acceleration signal which indicates acceleration in the second direction using the second capacitance,
calculates mutually different theoretical formulas for the first acceleration signal and the second acceleration signal respectively, and
corrects the first acceleration signal and the second acceleration signal, using the inversion formula of the theoretical formula which has been calculated for the first acceleration signal and the second acceleration signal respectively.

10. The method for correcting non-linear output according to Claim 9, wherein
a design value of a distance between the movable electrode and the first fixed electrode and a design value of a distance between the movable electrode and the third fixed electrode are the same, and
the theoretical formula is calculated using deviations of the distances between the movable electrode and the first and third fixed electrodes from the design values, with the deviations driving from manufacture of the electrostatic capacitance sensor.

11. The correction method for non-linear output according to any one of Claims 7 to 10, wherein
acceleration is applied to the electrostatic capacitance sensor and the output of the electrostatic capacitance sensor is measured, then a coefficient of the theoretical formula is determined based on the measured results of the electrostatic capacitance sensor and the acceleration applied to the electrostatic capacitance sensor, thereby correcting the non-linear output, using the inversion formula of the theoretical formula after the coefficient is determined.

12. The correction method for non-linear output according to Claim 11, wherein
a range of acceleration that is applied to the electrostatic capacitance sensor in the first direction and a range of acceleration that is applied to the capacitance sensor in the second direction, which are to determine the coefficient of the theoretical formula, are different from each other.

13. The correction method for non-linear output according to Claim 12, wherein
the range of acceleration that is applied to the electrostatic capacitance sensor to determine the coefficient of the theoretical formula used for correcting the first acceleration signal includes both a negative value and a positive value.

14. The method for correcting non-linear output according to Claim 12 or 13, wherein
the range of acceleration that is applied to the electrostatic capacitance sensor to determine the coefficient of the theoretical formula used for correcting the second acceleration signal includes only one of a negative value and a positive value.

15. The method for correcting non-linear output according to any one of Claims 11 to 14, wherein
acceleration is applied to the electrostatic capacitance sensor, using gravitational acceleration to determine the coefficient of the theoretical formula.

16. The method for correcting non-linear output according to Claim 15, wherein
the range of acceleration that is applied to the electrostatic capacitance sensor in the first direction is -1G or more and +1G or less.

17. The method for correcting non-linear output according to Claim 15 or 16, wherein
the range of acceleration that is applied to the electrostatic capacitance sensor in the second direction is -2G or more and 0G or less.

18. The method for correcting non-linear output according to any one of Claims 15 to 17, wherein
the gravitational acceleration at a location where the output of the electrostatic capacitance sensor is corrected is measured, and the measured magnitude of the gravitational acceleration is used as a reference.

FIG. 1

**FIG. 2**

**FIG. 3**

$$d1 = d0 - \Delta d$$
$$d2 = d0 + \Delta d$$

FIG. 4

SENSOR OUTPUT [V]

SENSOR OUTPUT

ACCELERATION [G]

**FIG. 5**

FIG. 6

**FIG. 7**

24

$$d3 = d0 - \Delta d2$$

FIG. 8

SENSOR OUTPUT [V]

SENSOR OUTPUT

ACCELERATION [G]

**FIG. 9**

ACCELERATION [G]

CORRECTION
FORMULA

CORRECTION
RESULT

SENSOR OUTPUT [V]

**FIG. 10**

FIG. 11

FIG. 12

d01 = d0 − dofst
d02 = d0 + dofst

**FIG. 13**

$$d1 = d0 - dofst - \Delta d$$
$$d2 = d0 + dofst + \Delta d$$

**FIG. 14**

SENSOR OUTPUT [V]

INFLECTION POINT
DEVIATES FROM
ORIGIN

SENSOR OUTPUT

ACCELERATION [G]

**FIG. 15**

FIG. 16

d03 = d0 − dofst2

**FIG. 17**

$$d3 = d0 - dofst2 - \triangle d2$$

FIG. 18

SENSOR OUTPUT [F]

INFLECTION POINT
DEVIATES FROM
ORIGIN

SENSOR OUTPUT

ACCELERATION [G]

Δ Cofst

aofst

**FIG. 19**

Z AXIS

STANDARD INSTALLATION
STATE OF ELECTROSTATIC
CAPACITANCE SENSOR (0G)

X AXIS

Y AXIS

(a)

X AXIS          X AXIS 0G
               (STANDARD INSTALLATION STATE)

INCLINED -90°                    INCLINED +90°

X AXIS -1G        X AXIS 1G

(b)

Y AXIS          Y AXIS 0G
               (STANDARD INSTALLATION STATE)

INCLINED +90°                    INCLINED -90°

Y AXIS 1G        Y AXIS -1G

(c)

Z AXIS          Z AXIS 0G
               (STANDARD INSTALLATION STATE)

INCLINED
180°

Z AXIS -2G

(d)

**FIG. 20**

37

## INTERNATIONAL SEARCH REPORT

| | International application No. |
|---|---|
| | PCT/JP2014/059634 |

**A. CLASSIFICATION OF SUBJECT MATTER**
*G01P21/00*(2006.01)i, *G01P15/125*(2006.01)i, *G01P15/18*(2013.01)i

According to International Patent Classification (IPC) or to both national classification and IPC

**B. FIELDS SEARCHED**

Minimum documentation searched (classification system followed by classification symbols)
G01P21/00, G01P15/00-15/18

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 9-54114 A (Murata Mfg. Co., Ltd.),<br>25 February 1997 (25.02.1997),<br>paragraphs [0050] to [0058]; fig. 12 to 14<br>(Family: none) | 1,5-6<br>2-4,7-18 |
| Y<br>A | JP 2002-22760 A (Takata Corp.),<br>23 January 2002 (23.01.2002),<br>paragraphs [0045] to [0047]<br>(Family: none) | 1,5-6<br>2-4,7-18 |
| A | WO 2001/096815 A1 (Omron Corp.),<br>20 December 2001 (20.12.2001),<br>description, page 6, lines 1 to 3<br>& JP 3680834 B | 5 |

☒ Further documents are listed in the continuation of Box C.  ☐ See patent family annex.

| | |
|---|---|
| *    Special categories of cited documents:<br>"A"  document defining the general state of the art which is not considered    to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>    01 July, 2014 (01.07.14) | Date of mailing of the international search report<br>    15 July, 2014 (15.07.14) |
|---|---|
| Name and mailing address of the ISA/<br>    Japanese Patent Office | Authorized officer |
| Facsimile No. | Telephone No. |

Form PCT/ISA/210 (second sheet) (July 2009)

**INTERNATIONAL SEARCH REPORT**

| International application No. |
|---|
| PCT/JP2014/059634 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2009-20094 A  (Freescale Semiconductor Inc.), 29 January 2009 (29.01.2009), entire text; all drawings & CN 101344535 A           & US 2009/0013754 A1 | 1-18 |
| A | JP 2007-198789 A  (Sharp Corp.), 09 August 2007 (09.08.2007), entire text; all drawings (Family: none) | 1-18 |
| A | JP 2003-248017 A  (Toyoda Machine Works, Ltd.), 05 September 2003 (05.09.2003), entire text; all drawings (Family: none) | 1-18 |

Form PCT/ISA/210 (continuation of second sheet) (July 2009)

**EP 2 982 991 A1**

**Patent documents cited in the description**

- JP H2110383 B
- JP H572225 B
- JP H5340958 B

- JP H8313552 B
- JP H7120498 B
- JP 2013077145 A